# EUROPEAN PATENT APPLICATION

(11) **EP 2 296 450 A1**
(43) Date of publication of application: **16.03.2011**
(21) Application number: 10170540.8
(22) Date of filing: 22.07.2010
(51) Int. Cl.: H05K 3/00, H05K 1/02

(54) **Printed wiring board, electronic device and manufacturing method of the printed wiring board**

(30) Priority: 27.07.2009 JP 2009174568
(71) Applicant: Fujitsu Limited, Kawasaki-shi, Kanagawa 211-8588 (JP)
(72) Inventor: Sugimoto, Kaoru, Kawasaki-shi Kanagawa 211-8588 (JP); Kobayashi, Katsuhiko, Kawasaki-shi Kanagawa 211-8588 (JP)
(74) Representative: Wilding, Frances Ward

(57) **Abstract**

A printed wiring board (20B) is formed by performing cutting in a rectangular region having sides (21B,22B) which are oblique to sides of a rectangular sheet material (10B) from the rectangular sheet material (10B) formed from glass cloth fibers. In the printed wiring board (20B), at least one corner (211B,221B) is cut out in a state in which the one corner (211B,221B) extends off a cuttable region of the rectangular sheet material (10B).

## Description

### FIELD

The embodiment discussed herein is related to a printed wiring board, an electronic device provided with the printed wiring board and a manufacturing method of the printed wiring board.

### BACKGROUND

In some printed wiring boards, mesh fibers constituted of warp fibers and weft fibers are embedded for suppressing extension and contraction due to temperature and humidity and for reinforcing strength. As the fibers to be embedded in the printed wiring boards, glass fibers are typically used.

In recent years, wiring on the printed wiring board has become denser, and the signals which are transmitted by the wiring have become higher-frequency signals. In accordance with this, higher characteristics have been required of printed wiring boards. When the characteristics of the printed wiring boards are to be further enhanced, the relation of the direction of the embedded fibers and the direction of the wiring becomes a problem, and it is known that the characteristics are more enhanced when these directions are slightly shifted from each other than when these directions correspond to each other. On printed wiring boards, wirings are generally printed parallel with one side of the printed wiring boards. Therefore, when such a printed wiring board having the directions of fibers and wirings shifted from each other is cut out from the sheet material with the fibers being embedded, which becomes a basis for cutting the printed wiring board, the printed wiring board is cut out so that the sides are formed, which are oblique with respect to the direction of extension of the fibers in the sheet material.

Here, the sheet material to be the basis for cutting of the printed wiring board is a rectangular sheet material, and in the sheet material, fibers extending in the direction along one side of the rectangular sheet material and the direction orthogonal to that direction are embedded. Therefore, when the rectangular printed wiring board with the directions of the fibers and wirings being shifted from each other is to be cut out from the sheet material, the printed wiring board is cut out in the orientation in which the sides of the printed board become oblique with respect to the sides of the sheet material. However, when the printed wiring board is to be cut out obliquely, a sheet material in a larger size needs to be prepared, as compared with the case of cutting the printed wiring board so that the sides of the sheet material and the sides of the printed wiring board become parallel with each other. Preparation of the sheet material in a larger size is likely to increase the cost correspondingly.

Meanwhile, it is conceivable to embed fibers obliquely in the process of manufacture of the sheet material to be the basis for cutting of the printed wiring board. When the printed wiring board is to be cut out from the sheet material in which the fibers are obliquely embedded, the printed wiring board may be cut out so that the sides of the sheet material and the sides of the printed wiring board cut out from the sheet material become parallel with each other as in the conventional technique. In this case, as compared with the case of cutting the printed wiring board is obliquely, waste is not caused at the point of time when the printed wiring board is cut out, but large waste is likely to occur in the step of manufacture of the sheet material.

Here, in order that a plating solution hardly penetrate to the wiring along the fibers embedded in the printed wiring board from the through-holes provided in the printed wiring board, it is proposed to make the direction of the embedded fibers and the direction of the wiring differ from each other.

Patent document 1: Japanese Laid-open Patent Publication No. S61-42992.
Patent document 2: Japanese Laid-open Patent Publication No. S61-47844.

### SUMMARY

Accordingly, it is desirable to provide a printed wiring board, an electronic device and a manufacturing method of the printed wiring board which suppress cost.

According to embodiments of a first aspect of the invention, a first printed wiring board of the printed wiring board embodying the present invention is formed by performing cutting in a rectangular region having sides oblique to sides of a rectangular sheet material from the rectangular sheet material formed from glass cloth fibers. The first printed wiring board is a printed wiring board which is cut out in a state in which at least one corner of the printed wiring board extends off a cuttable region of the rectangular sheet material.

Further, according to embodiments of a second aspect of the invention, a second printed wiring board of the printed wiring board embodying the present invention is a printed wiring board which is formed from glass cloth fibers and has each side formed without being along stitches of the glass cloth fibers. Here, in the second printed wiring board, at least one corner of the printed wiring board has a chipped region along at least one stitch of the glass cloth fibers.

Further, according to embodiments of a third aspect of the invention, an electronic device is provided with a printed wiring board embodying the present invention.

Further, according to embodiments of a fourth aspect of the invention, a manufacturing method includes cutting out, from a rectangular sheet material formed from glass cloth fibers, a rectangular region having sides which are oblique to sides of the rectangular sheet material in a state in which at least one side extends off a cuttable region of the rectangular sheet material.

### BRIEF DESCRIPTION OF DRAWINGS

Preferred features of the present invention will now be described, purely by way of example, with reference to the accompanying drawings, in which:-
FIG. 1 is a view illustrating sheet materials to be a basis for cutting of printed wiring boards, and layouts of the boards which are cut out from the sheet materials;
FIG. 2 is a view illustrating sheet materials to be a basis for cutting of printed wiring boards, and layouts of the boards which are cut out from the sheet materials similarly as in FIG. 1; and
FIG. 3 is a chart illustrating a procedure to determination of the layout of the printed wiring board on the sheet material.

### DESCRIPTION OF EMBODIMENT

Hereinafter, an embodiment of the present invention will be described.

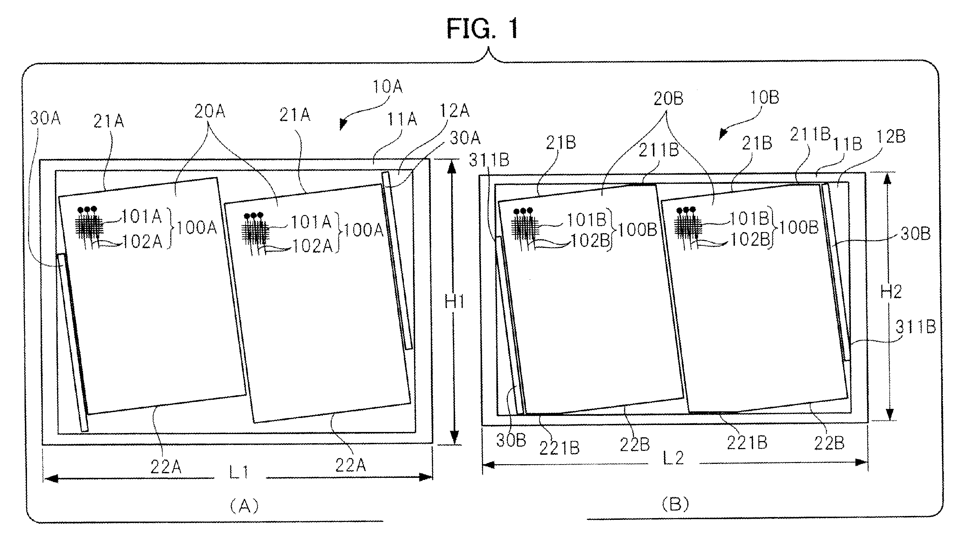

FIG. 1 is a view illustrating sheet materials to be a basis of cutting of printed wiring boards, and layouts of the boards which are cut out from the sheet materials. Part (A) of FIG. 1 illustrates a comparative example, and part (B) of FIG. 1 illustrates an example.

The sheet material to be the basis of cutting of the printed wiring board is a rectangular sheet material, and sheet materials of a number of sizes are present. However, selectable sizes differ stepwise as sheet materials 10A and 10B illustrated in parts (A) and (B) of FIG. 1, and the sheet materials in arbitrary sizes between them may not be selected. Further, in the sheet materials 10A and 10B, there are band-shaped off-product areas 11A and 11B which extend on whole perimeters of the sheet materials 10A and 10B, and product areas 12A and 12B surrounded by the off-product areas 11A and 11B. The off-product areas 11A and 11B are areas for handling the sheet materials 10A and 10B in such a manner that holes for positioning the sheet materials 10A and 10B are formed, and are areas which may not be used as products. The product areas 12A and 12B which are inside from the off-product areas 11A and 11B are cuttable areas which may be used as the printed wiring boards.

Further, glass fibers which extend vertically and laterally and expand in a mesh shape are embedded in the sheet materials 10A and 10B.

Parts (A) and (B) of FIG. 1 illustrate marks 100A and 100B which include glass fibers 101A and 101B as schematic views extending vertically and laterally, and wirings 102A and 102B extending on the printed wiring boards 20A and 20B similarly as schematic views, for comprehensiveness. These marks 100A and 100B are not drawn on the actual sheet materials 10A and 10B, but are illustrated for comprehensiveness in FIG. 1.

As illustrated in these marks 100A and 100B, the glass fibers 101A and 101B extend in the directions parallel with and orthogonal to one sides of the sheet materials 10A and 10B. Meanwhile, the wirings 102A and 102B on the printed wiring boards 20A and 20B extend in the oblique directions when the sheet materials 10A and 10B are set as the references. This is based on the knowledge that the electric characteristics of the wirings 102A and 102B may be enhanced by extending the wirings 102A and 102B obliquely with respect to the glass fibers 101A and 101B.

In this case, in order to form the wirings 102A and 102B parallel with one sides of the printed wiring board 20A and 20B, the sheet materials 10A and 10B are obliquely cut as illustrated in parts (A) and (B) of FIG. 1.

The description so far is the same in the case of the comparative example illustrated in part (A) of FIG. 1, and in the case of the example illustrated in part (B) of FIG. 1. In this case, in the comparative example of part (A) of FIG. 1, in order that the printed wiring board 20A is cut out into a rectangular shape correctly, the sheet material 10A in a large size as compared with part (B) of FIG. 1 is adopted. In contrast with this, in the case of the example illustrated in part (B) of FIG. 1, the printed wiring board 20B is in the shape as follows. More specifically, when the rectangle which circumscribes the printed wiring board 20B is considered, a first portion 211B which comes close to one corner (right side corner in this case) of a first side (side overlapping an upper side 21B in this case) of the rectangle has the shape which is cut obliquely with respect to the first side. Similarly to this, in the case of the example of part (B) of FIG. 1, a second portion 221B also has the shape which is cut parallel with the first portion 211B. The second portion 221B is a portion, which comes close to a corner (lower left corner of the rectangle) located diagonally opposite to the one corner (upper right corner of the rectangle), of the second side (side overlapping a lower side 22B in this case) parallel with the first side of the rectangle.

These first portion 211B and second portion 221B are formed not to extend off the product area 12B of the sheet material 10B due to the dimensional limitation of the sheet material 10B. As compared with the printed wiring board 20A in which the upper side 21A and the lower side 22A are linearly cut as part (A) of FIG. 1, a decrease of the area of the printed wiring board 20B due to the presence of the first portion 211B and the second portion 221B in the shapes which are cut obliquely is very small. Therefore, a large problem does not especially occur as the printed wiring board. Meanwhile, as is known by comparison of part (A) of FIG. 1 and part (B) of FIG. 1, by forming the upper side 21B and the lower side 22B of the printed wiring board 20B into the shapes slightly cut, the sheet material 10B of the next smaller size may be used. Thereby, an increase in cost which accompanies oblique cutting of the printed wiring board from the sheet material is suppressed.

Further, as illustrated in parts (A) and (B) of FIG. 1, when the printed wiring boards 20A and 20B are cut out from the sheet materials 10A and 10B, coupon boards 30A and 30B are cut out from the regions, which are adjacent to the printed wiring boards 20A and 20B, of the sheet materials 10A and 10B. The coupon boards 30A and 30B are boards for evaluating the characteristics of the printed wiring boards 20A and 20B which are cut out from the same sheet materials 10A and 10B. In the case of part (A) of FIG. 1, the coupon board 30A has a long rectangular shape, but in the case of part (B) of FIG. 1, the coupon board 30B has the shape formed by cutting one portion 311B in contact with the off-product area 12B of the sheet material 10B from the long rectangular shape. About the coupon board 30B, a decrease in the area as a result of the one portion 311B being cut is small, and a problem does not especially occurs in the evaluation of the characteristics of the printed wiring board 20B.

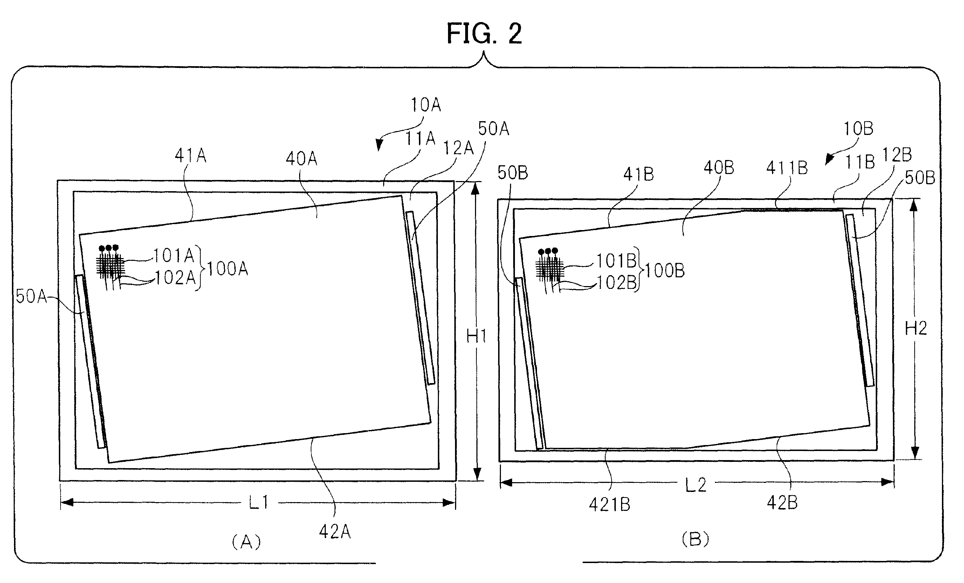

FIG. 2 is a view illustrating sheet materials to be a basis for cutting of printed wiring boards, and layouts of the boards which are cut out from the sheet materials, as in FIG. 1. However, in this case, in each of part (A) of FIG. 2 and part (B) of FIG. 2, only one printed wiring board in a large size is illustrated. As in FIG. 1, part (A) of FIG. 2 illustrates a comparative example, and part (B) of FIG. 2 illustrates an example.

The sheet material 10A illustrated in part (A) of FIG. 2 is in the same size as the sheet material 10A illustrated in part (A) of FIG. 1. The sheet material 10B illustrated in part (B) of FIG. 2 is in the same size as the sheet material 10B illustrated in part (B) of FIG. 1. These sheet materials 10A and 10B have off-product areas 11A and 11B surrounding whole perimeters, and the product areas 12A and 12B including the regions which may be cut out as the printed wiring boards and are surrounded by the off-product areas 11A and 11B. Further, glass fibers which extend vertically and laterally and expand in a mesh shape are embedded in the sheet materials 10A and 10B as in the case of FIG. 1.

Further, parts (A) and (B) of FIG. 2 also illustrate the same marks 100A and 100B as in parts (A) and (B) of FIG. 1. As represented by these marks 100A and 100B, the glass fibers 101A and 101B embedded in the sheet materials 10A and 10B extend in the directions parallel with and orthogonal to one sides of the sheet materials 10A and 10B. Meanwhile, the wirings 101A and 101B on the printed wiring boards 40A and 40B extend in the oblique directions when the sheet materials 10A and 10B are set as the references. The reason of this is based on the knowledge that the electric characteristics of the wirings 102A and 102B may be enhanced by obliquely extending the wirings 102A and 102B with respect to the glass fibers 101A and 101B as described above.

In the examples of FIG. 2, in order to form one sides of the printed wiring boards 40A and 40B parallel with the wirings 102A and 102B on the printed wiring boards 40A and 40B, the printed wiring boards 40A and 40B are also cut out obliquely with respect to the sheet materials 10A and 10B, as in the case of FIG. 1.

In the case of the comparative example illustrated in part (A) of FIG. 2, the printed wiring board 40A and a coupon board 50A which is cut out directly beside the printed wiring board 40A both have accurate rectangular shapes. In contrast with this, in the case of the example illustrated in part (B) of FIG. 2, because of the dimensional limitations of the product area 12B of the sheet material 10B, an upper side 41B and a lower side 42B of the printed wiring board 40B have the shapes in which one portions 411B and 421B which is close to one corners located diagonally opposite to each other of the rectangle in which the printed wiring board 40B is inscribed. In the case of the example illustrated in part (B) of FIG. 2, the coupon board 50B is cut out into a long rectangular shape as in part (A) of FIG. 1.

The area of the region cut from the rectangle of the printed wiring board 40B illustrated in FIG. 2(B) part (B) of FIG. 2 is very small, and hardly causes a problem as the printed wiring board, while an increase in cost accompanying the oblique cutting may be suppressed by adopting the sheet material 10B in a small size.

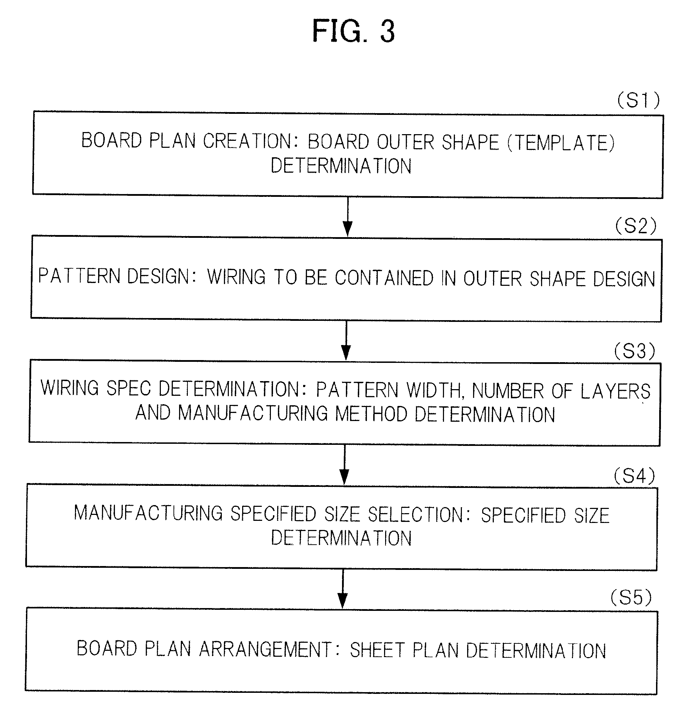

FIG. 3 is a chart illustrating the procedure to determination of layout of the printed wiring board on the sheet material.

Here, the outer shape (outline) of the printed wiring board is determined (step S1), and thereafter, pattern design is performed, that is, the wiring which is placed inside the outer shape is designed (step S2). In the pattern design, the wiring pattern, which is given an allowance in the corners or perimeter, is desirably designed so that the wiring is not cut even if the corners are slightly cut, as shown in part (B) of FIG. 1 and part (B) of FIG. 2.

Next, determination of the wiring specifications is performed (step S3). Here, the width of the wiring pattern, the number of wiring layers and the manufacturing method of the wiring are determined.

Next, manufacturing specified size, that is, selection by the size of the sheet material is performed (step S4). A printed wiring board plan is disposed on the sheet material, the sheet plan, that is, the drawing of the sheet material, on which the plan of cutting the printed wiring board and the coupon board is drawn, is determined (step S5).

Here, in designing of the wiring pattern (step S2), a little allowance is given to the perimeter so that the wiring pattern is not arranged on the area close to the perimeter of the printed wiring board, whereby the sheet material in the next smaller size may be selected as in part (B) of FIG. 1 and part (B) of FIG. 2, and the cost may be reduced. Alternatively, in board plan creation (step S1), the board plan in the shape with a part being cut as in part (B) of FIG. 1 and part (B) of FIG. 2 may be created.

The printed wiring boards illustrated in part (B) of FIG. 1 and part (B) of FIG. 2 have the shapes in which both the upper sides 21B and 41B and the lower sides 22B and 42B are cut, but the printed wiring board on the sheet material may be moved upward or downward so that only one sides of the upper sides 21B and 41B and the lower sides 22B and 42B are cut. Further, in the case of part (B) of FIG. 1 and part (B) of FIG. 2, the sides at the left and right of the printed wiring boards 20A and 40A are formed by straight lines, but when there is no allowance in the lateral direction, the cut position of the printed wiring board may be determined so that part of the left and right sides may be cut.

According to the printed wiring board, the electronic device and the manufacturing method of the printed wiring board embodying the present invention, at the time of performing cutting obliquely to the embedded fibers, the size of the sheet material to be the basis of the cutting is suppressed, and therefore, cost may be suppressed.

## Claims

1. A printed wiring board formed by performing cutting in a rectangular region having sides which are oblique to sides of a rectangular sheet material from the rectangular sheet material formed from glass cloth fibers,
wherein at least one corner of the printed wiring board is cut out in a state in which the one corner extends off a cuttable region of the rectangular sheet material.

2. The printed wiring board according to claim 1,
wherein two corners diagonally opposite to each other are cut out in a state in which the two corners extend off the cuttable region of the rectangular sheet material.

3. A printed wiring board which is formed from glass cloth fibers and whose each side is formed without being along stitches of the glass cloth fibers,
wherein at least one corner of the printed wiring board has a chipped region along at least one stitch of the glass cloth fibers.

4. The printed wiring board according to claim 3,
wherein two corners diagonally opposite to each other have chipped regions along at least one stitch of the glass cloth fibers.

5. An Electronic device provided with a printed wiring board formed by performing cutting in a rectangular region having sides which are oblique to sides of a rectangular sheet material from the rectangular sheet material formed from glass cloth fibers,
wherein at least one corner is cut out in a state in which the one corner extends off a cuttable region of the rectangular sheet material.

6. The electronic device according to claim 5,
wherein two corners diagonally opposite to each other of the printed wiring board are cut out in a state in which the two corners extend off the cuttable region of the rectangular sheet material.

7. A manufacturing method of a printed wiring board, comprising
cutting out, from a rectangular sheet material formed from glass cloth fibers, a rectangular region having sides which are oblique to sides of the rectangular sheet material in a state in which at least one side extends off a cuttable region of the rectangular sheet material.

8. The manufacturing method of the printed wiring board according to claim 7,
wherein two corners diagonally opposite to each other of the printed wiring board are cut in a state in which the two corners extend off the cuttable region of the rectangular sheet material.

9. An electronic device with the printed wiring board according to any of claims 1 to 4.
